# EUROPEAN PATENT APPLICATION

(11) **EP 4 550 970 A1**
(43) Date of publication of application: **07.05.2025**
(21) Application number: 24210436.2
(22) Date of filing: 01.11.2024
(51) Int. Cl.: H10D 8/01, H10D 8/00, H10D 12/00, H10D 30/66, H10D 62/10, H10D 64/00

(54) **SEMICONDUCTOR DEVICE AND MANUFACTURING METHOD THEREOF**

(30) Priority: 02.11.2023 CN 202311451617
(71) Applicant: Nexperia B.V., 6534 AB Nijmegen (NL); Nexperia Technology (Shanghai) Ltd., Shanghai 200025 (CN)
(72) Inventor: Xiang, Junli, Shanghai (CN); Zhu, Chunlin, Shanghai (CN); Jiang, Ke, Shanghai (CN)
(74) Representative: Pjanovic, Ilija

(57) **Abstract**

Provided is a semiconductor device and a manufacturing method thereof. The semiconductor device has an active area and a terminal area surrounding the active area, and includes: a base region, located in the active area and on a second side of a semiconductor substrate having a first conductivity type; a plurality of annular subregions, located in the terminal area and on the second side of the substrate, and spaced apart from each other; an insulating layer, located in the terminal area and on one sides of the plurality of annular subregions away from the substrate, and provided with a plurality of insulating layer openings; and a first conductive layer, located in the active area and the terminal area and on one sides of the base region and the insulating layer away from the substrate. The plurality of annular subregions include a first annular subregion in contact with the base region. The first annular subregion includes a plurality of annular structures in contact with each other, each of the annular structures corresponding to one insulating layer opening. All the annular structures contact the first conductive layer through the corresponding insulating layer openings. Each of the base region, the annular subregions and the annular structures has a second conductivity type.

## Description

### Technical Field

The present disclosure relates to the field of semiconductors, and more particularly, to a semiconductor device having an active area and a terminal area surrounding the active area, and a manufacturing method thereof.

### Background

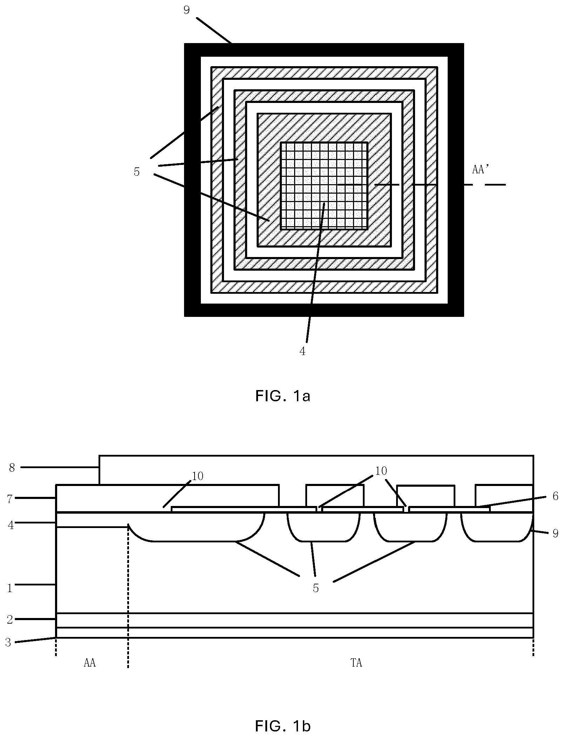

In the existing semiconductor device, taking an ultra-fast diode (hyper-fast diode) as an example, when the ultra-fast diode is turned off at a high speed and a high DC voltage, a dynamic avalanche breakdown phenomenon may occur. The current distribution and electric field distribution inside the diode become uneven, resulting in current concentration, easily causing the device to burn out. There may be current filaments and high electric field peaks at pn junctions and bottom nn+ junctions, and thus the diode may be damaged. The ultra-fast diode as shown in FIG. 1 in the related art has the above problems.

Other examples e.g. a metal-oxide-semiconductor field effect transistor (MOSFET) and an insulated-gate bipolar transistor (IGBT) also have the same problems.

Therefore, it is necessary to provide an improved semiconductor device to solve the aforementioned technical problems.

### Summary

In the first aspect, the present disclosure provides a semiconductor device, having an active area and a terminal area surrounding the active area. The semiconductor device includes: a semiconductor substrate having a first conductivity type, the semiconductor substrate including a first side and a second side opposite to each other; a base region having a second conductivity type, located in the active area and on the second side of the semiconductor substrate; a plurality of annular subregions having the second conductivity type, located in the terminal area and on the second side of the semiconductor substrate, and spaced apart from each other; an insulating layer, located in the terminal area and on one sides of the plurality of annular subregions away from the semiconductor substrate, where the insulating layer is provided with a first insulating layer opening; and a first conductive layer, located in the active area and the terminal area and on one sides of the base region and the insulating layer away from the semiconductor substrate. The plurality of annular subregions include a first annular subregion, and the first annular subregion is in contact with the base region; the first conductive layer includes a first portion, and a plurality of second portions surrounding the first portion in the terminal area, where the first portion is spaced apart from the plurality of second portions and extends from a part of the active area, crossing a junction between the active area and the terminal area, to a part of the terminal area, and the plurality of second portions are spaced apart from each other; and the first annular subregion includes a plurality of annular structures having the second conductivity type and in contact with each other, and the base region and the first annular structure of the plurality of annular structures in contact with the base region come into contact with the first portion through the first insulating layer opening.

In some embodiments, the insulating layer is further provided with a plurality of second insulating layer openings; each of the second portions of the first conductive layer corresponds to one second insulating layer opening, and all the second portions respectively correspond to the different second insulating layer openings; and except for the first annular structure, the other annular structures are respectively in contact with the corresponding second portions through the respective second insulating layer openings.

In some embodiments, the first conductivity type is n-type; the second conductivity type is p-type; and the semiconductor substrate is an n-type region, the base region is a p-type region, the plurality of annular subregions are a plurality of p-type annular subregions, the first annular subregion is a first p-type annular subregion, and the annular structures are p-type annular structures.

In some embodiments, the plurality of p-type annular subregions are all annular and are arranged around the p-type region; in any two adjacent p-type annular structures, the p-type annular structure away from the p-type region is arranged around the p-type annular structure close to the p-type region; orthographic projections of any two adjacent p-type annular structures on the n-type region overlap each other, so that each of the p-type annular structures includes an overlapping area and a non-overlapping area; the orthographic projections are formed on a surface of the n-type region by the p-type annular structures perpendicular to the surface of the n-type region; and the depth of the part of each of the p-type annular structures in the non-overlapping area is greater than that of the part of each of the p-type annular structures in the overlapping area.

In some embodiments, the plurality of p-type annular subregions further include a plurality of second p-type annular subregions distributed around the first p-type annular subregion and spaced apart from each other, the plurality of second p-type annular subregions being sequentially disposed in a direction from the active area to the terminal area; and the plurality of second p-type annular subregions respectively contact the corresponding second portions through the corresponding second insulating layer openings of the plurality of second insulating layer openings.

In some embodiments, in a plane perpendicular to a surface of the n-type region and parallel to a direction from the active area to the terminal area, a recess is formed in an area where any two adjacent p-type annular structures are in contact with each other; and the recess is recessed towards a direction away from the n-type region.

In some embodiments, the doping concentration of the plurality of p-type annular structures is different from that of the plurality of second p-type annular subregions; and/or the doping depth of the plurality of p-type annular structures is different from that of the plurality of second p-type annular subregions.

In some embodiments, the doping depth of the plurality of p-type annular subregions is greater than that of the p-type region.

In some embodiments, the plurality of p-type annular structures include two or three p-type annular structures.

In some embodiments, an orthographic projection of the p-type annular structure contacting the p-type region on the n-type region overlaps an orthographic projection of the p-type region on the n-type region, and the orthographic projection is a projection formed on the surface of the n-type region by the p-type annular structure perpendicular to the surface of the n-type region.

In some embodiments, the doping concentration and doping depth of the part of each of the p-type annular structures in the overlapping area are smaller than those of the other parts of each of the p-type annular structures, respectively.

In another aspect, the present disclosure provides a method for forming a semiconductor device, where the semiconductor device has an active area and a terminal area surrounding the active area; the method includes: providing a semiconductor substrate having a first conductivity type, the semiconductor substrate including a first side and a second side opposite to each other; forming a base region having a second conductivity type on the second side of the semiconductor substrate, the base region being located in the active area; forming a plurality of annular subregions having the second conductivity type on the second side of the semiconductor substrate, the annular subregions being located in the terminal area and spaced apart from each other; forming an insulating layer on one sides of the plurality of annular subregions away from the semiconductor substrate, the insulating layer being located in the terminal area and provided with a first insulating layer opening; and forming a first conductive layer on one sides of the base region and the insulating layer away from the semiconductor substrate, the first conductive layer being located in the active area and the terminal area, where forming the plurality of annular subregions includes forming a first annular subregion, the first annular subregion being in contact with the base region; forming the first conductive layer includes forming a first portion, and forming a plurality of second portions surrounding the first portion in the terminal area and spaced apart from each other, where the first portion is formed to be spaced apart from the plurality of second portions, and is allowed to extend from a part of the active area, crossing a junction between the active area and the terminal area, to a part of the terminal area; and forming the first annular subregion includes forming a plurality of annular structures having the second conductivity type and in contact with each other, where the base region and the first annular structure of the plurality of annular structures in contact with the base region come into contact with the first portion through the first insulating layer opening.

In some embodiments, the insulating layer is further provided with a plurality of second insulating layer openings; each of the second portions of the first conductive layer corresponds to one second insulating layer opening, and all the second portions respectively correspond to the different second insulating layer openings; and except for the first annular structure, the other annular structures are respectively in contact with the corresponding second portions through the respective second insulating layer openings.

In some embodiments, the first conductivity type is n-type; the second conductivity type is p-type; and the semiconductor substrate is an n-type region, the base region is a p-type region, the plurality of annular subregions are a plurality of p-type annular subregions, the first annular subregion is a first p-type annular subregion, and the annular structures are p-type annular structures.

In some embodiments, forming the plurality of p-type annular subregions further includes: forming a plurality of second p-type annular subregions spaced apart from each other, the plurality of second p-type annular subregions being sequentially disposed in a direction from the active area to the terminal area, and spaced apart from the first p-type annular subregion, where forming the first p-type annular subregion and forming the plurality of second p-type annular subregions are performed simultaneously.

In some embodiments, forming the plurality of p-type annular subregions includes: coating the second side of the n-type region with a photoresist layer to form a photoresist pattern, forming a plurality of p-type annular layers and a plurality of second p-type annular sublayers by means of ion implantation under the condition that the photoresist pattern is used as a mask, with the adjacent p-type annular layers being spaced apart by a first spacing, and the adjacent second p-type annular sublayers being spaced apart by a second spacing, where the first spacing is smaller than the second spacing; removing the photoresist pattern; and performing high-temperature treatment on the plurality of p-type annular layers and the plurality of second p-type annular sublayers to further diffuse the implanted ions, making it possible to form a plurality of p-type annular structures and the plurality of second p-type annular subregions, and further allowing orthographic projections of any two adjacent p-type annular structures on the n-type region to overlap each other, with each of the p-type annular structures including an overlapping area and a non-overlapping area, the orthographic projections being formed on a surface of the n-type region by the p-type annular structures perpendicular to the surface of the n-type region, and the orthogonal projections of any two adjacent second p-type annular subregions on the n-type region do not overlap each other, where the depth of the part of each of the p-type annular structures in the non-overlapping area is greater than that of the part of each of the p-type annular structures in the overlapping area.

In some embodiments, forming the plurality of p-type annular subregions includes: coating the second side of the n-type region with a photoresist layer to form a photoresist pattern, forming a plurality of p-type annular layers by means of ion implantation under the condition that the photoresist pattern is used as a mask, with the adjacent p-type annular layers being spaced apart by a first spacing; removing the photoresist pattern; and performing high-temperature treatment on the plurality of p-type annular layers to further diffuse the implanted ions, making it possible to form a plurality of p-type annular structures, and further allowing orthographic projections of any two adjacent p-type annular structures on the n-type region to overlap each other, with each of the p-type annular structures including an overlapping area and a non-overlapping area, where the orthographic projections are formed on a surface of the n-type region by the p-type annular structures perpendicular to the surface of the n-type region; and the depth of the part of each of the p-type annular structures in the non-overlapping area is greater than that of the part of each of the p-type annular structures in the overlapping area.

### Brief Description of Figures

According to various disclosed embodiments, the following accompanying drawings are only examples for illustrative purposes and are not intended to limit the scope of the present disclosure.
FIG. 1a is a top view of the structure of a semiconductor device in the related art.
FIG. 1b is a cross-sectional view along a line AA' in FIG. 1a.
FIG. 2a is a top view of the structure of a semiconductor device provided according to an embodiment of the present disclosure.
FIG. 2b is a cross-sectional view along a line BB' in FIG. 2a.
FIG. 2c is a top view of another structure of the semiconductor device provided according to the embodiment of the present disclosure.
FIG. 2d is a cross-sectional view of another structure of the semiconductor device provided according to the embodiment of the present disclosure.
FIG. 3a is a top view of another structure of the semiconductor device provided according to the embodiment of the present disclosure.
FIG. 3b is a cross-sectional view along a line CC' in FIG. 3a.
FIG. 4 is a flowchart of a method for manufacturing the semiconductor device according to the embodiment according to the present disclosure.
FIG. 5a to FIG. 5e illustrate cross-sectional views of all steps of the method for manufacturing the semiconductor device according to the embodiment of the present disclosure.
FIG. 6 illustrates a specific process of step S3 of the method for manufacturing the semiconductor device according to the embodiment of the present disclosure.
FIG. 7a to FIG. 7d illustrate cross-sectional views of all steps of forming a plurality of p-type annular subregions on a second side of a semiconductor substrate in step S3 of the method for manufacturing the semiconductor device according to the embodiment of the present disclosure.
FIG. 8 illustrates a specific process of step S3 of a method for manufacturing the semiconductor device according to an alternative embodiment of the present disclosure.
FIG. 9 illustrates doping profiles of p-type annular subregions along a dashed line LL' in FIG. 2b according to the embodiment of the present disclosure.
FIG. 10 illustrates doping profiles of the p-type annular subregions along a dashed line MM' in FIG. 3b according to the embodiment of the present disclosure.
FIG. 11 illustrates a relationship between voltage drop and current of the semiconductor device according to the embodiment of the present disclosure.
FIG. 12 illustrates a relationship between blocking voltage and leakage current of the semiconductor device according to the embodiment of the present disclosure.
FIG. 13a shows the electric field distribution of the semiconductor device in the related art as shown in FIG. 1b.
FIG. 13b shows the electric field distribution of the semiconductor device according to the embodiment of the present disclosure as shown in FIG. 2b.
FIG. 13c shows the electric field distribution of the semiconductor device according to the embodiment of the present disclosure as shown in FIG. 3b.
FIG. 14a shows the current density distribution of the semiconductor device in the related art as shown in FIG. 1b.
FIG. 14b shows the current density distribution of the semiconductor device according to the embodiment of the present disclosure as shown in FIG. 2b.
FIG. 14c shows the current density distribution of the semiconductor device according to the embodiment of the present disclosure as shown in FIG. 3b.

### Detailed Description

The present disclosure will now be described more specifically with reference to the following embodiments. It should be noted that the following descriptions of some embodiments presented herein are for illustrative and descriptive purposes only. It is not exhaustive or limited to the precise form disclosed.

FIG. 1a is a top view of the structure of a semiconductor device in the related art. FIG. 1b is a cross-sectional view along a line AA' in FIG. 1a. As shown in FIG. 1a and FIG. 1b, the semiconductor device is divided into an active area AA and a terminal area TA surrounding the active area AA. The semiconductor device includes:
1) a semiconductor substrate having a first conductivity type, e.g. an n- type semiconductor substrate, where the semiconductor substrate may serve as an n-type region 1 of the semiconductor device as shown in FIG. 1a;
2) a contact region having the first conductivity type, e.g. an n+ type diffusion layer 2 in contact with the n-type region, where the contact region is located on a first side of the semiconductor substrate;
3) a base region having a second conductivity type, e.g. a p-type region 4, where the base region is located in the active area AA and on a second side of the n-type region 1 opposite to the first side;
4) a plurality of annular subregions having the second conductivity type, e.g. a plurality of p-type annular subregions 5 as shown in FIG. 1a, where the plurality of annular subregions are located in the terminal area TA and on the second side of the n-type region 1, and are spaced apart from each other;
5) an insulating layer 6, located in the terminal area TA and on one sides of the plurality of p-type annular subregions 5 away from the n-type region 1, where the insulating layer 6 is provided with a plurality of insulating layer openings 10; and
6) a first conductive layer 7, covering the active area AA and the terminal area TA on the second side of the n-type region 1, and located on one sides of the p-type region 4 and the insulating layer 6 away from the n-type region 1, where
7) the plurality of p-type annular subregions 5 include a p-type annular subregion in contact with the p-type region 4; each of the p-type annular subregions corresponds to one insulating layer opening 10; the plurality of p-type annular subregions 5 respectively correspond to the different insulating layer openings 10; and the plurality of p-type annular subregions 5 contact the first conductive layer 7 through the corresponding insulating layer openings 10.

The semiconductor device also includes the following layers:
a) a second conductive layer 3, located on the side of the n+ type diffusion layer 2 away from the n-type region 1;
b) a passivation layer 8, located on the side of the first conductive layer 7 away from the n-type region 1, the passivation layer 8 covering the entire terminal area TA in some embodiments; and
c) a channel stopper region 9, located in the terminal area TA and on the second side of the n-type region 1, and spaced apart from the plurality of p-type annular subregions 5.

In the existing semiconductor device, taking an ultra-fast diode as an example, when the ultra-fast diode is turned off at a high speed and a high DC voltage, a dynamic avalanche breakdown phenomenon may occur. The current distribution and electric field distribution inside the diode become uneven, resulting in current concentration, easily causing the device to burn out. There may be current filaments and high electric field peaks at pn junctions and bottom nn+ junctions, and thus the diode may be damaged.

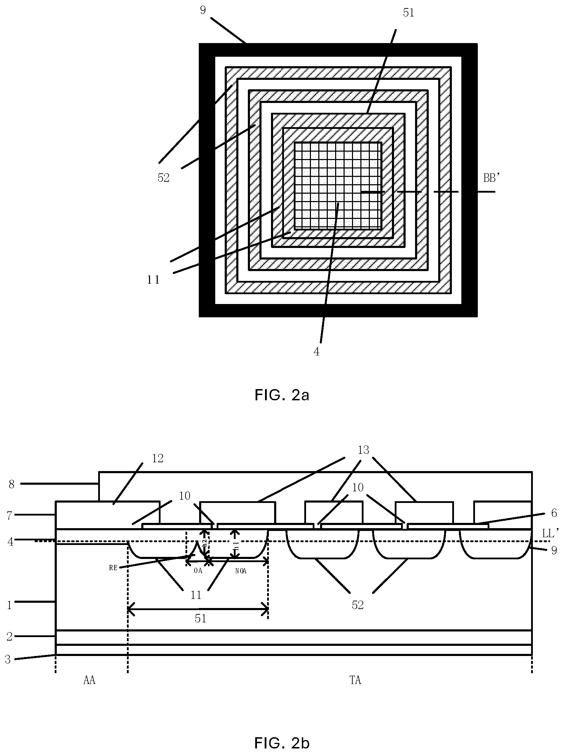

In order to solve the above technical problems in the related art, the present disclosure provides a semiconductor device. FIG. 2a is a top view of the structure of a semiconductor device provided according to an embodiment of the present disclosure. FIG. 2b is a cross-sectional view along a line BB' in FIG. 2a. In the embodiment of the present disclosure, compared with the structure of the semiconductor device shown in FIG. 1a and FIG. 1b, the difference lies in that, as shown in FIG. 2a and FIG. 2b, the plurality of p-type annular subregions 5 include a first p-type annular subregion 51. The first p-type annular subregion 51 is in contact with the p-type region 4. The first p-type annular subregion 51 includes a plurality of p-type annular structures 11 in contact with each other, each of the p-type annular structures 11 corresponding to one insulating layer opening 10; all the p-type annular structures 11 respectively correspond to the different insulating layer openings 10; and the plurality of p-type annular structures 11 contact the first conductive layer 7 through the corresponding insulating layer openings 10. Typically, the first conductivity type is n-type, and the second conductivity type is p-type. Alternatively, the first conductivity type is p-type, and the second conductivity type is n-type. In the embodiment of the present disclosure, an example with the first conductivity type being n-type and the second conductivity type being p-type is described.

In some embodiments, the first conductive layer 7 is used as an anode of the semiconductor device. In some embodiments, the second conductive layer 3 is used as a cathode of the semiconductor device. In some embodiments, a pn junction is formed at an interface between the plurality of p-type annular subregions 5 and the n-type region 1, and another pn junction is formed at an interface between the p-type region 4 and the n-type region 1 (the pn junctions are not shown in the drawings).

In some embodiments, the first conductive layer 7 may be made of metal, non-metal, or alloy materials. For example, the first conductive layer 7 may be made of aluminum-silicon alloy. In some embodiments, the second conductive layer 3 may have a single-layer or multi-layer structure. For example, the second conductive layer 3 may have a three-layer structure composed of titanium, nickel, and copper. In other embodiments, the second conductive layer 3 may be made of a metal material such as titanium, nickel, or silver. In some embodiments, the passivation layer 8 may be made of polyimide, silicon nitride, or the like.

In some embodiments, as shown in FIG. 2a, the plurality of p-type annular subregions 5 are all annular and are arranged around the p-type region 4. The p-type annular structures 11 adjacent to the p-type region 4 is arranged around the p-type region 4. In any two adjacent p-type annular structures 11, the p-type annular structure 11 away from the p-type region 4 is arranged around the p-type annular structure 11 close to the p-type region 4. Orthographic projections of any two adjacent p-type annular structures 11 on the n-type region 1 overlap each other, so that each of the p-type annular structures 11 includes an overlapping area OA and a non-overlapping area NOA. The orthographic projections are formed on a surface of the n-type region 1 by the p-type annular structures 11 perpendicular to the surface of the n-type region 1. The depth h1 of the part of each of the p-type annular structures 11 in the non-overlapping area NOA is greater than the depth h2 of the part of each of the p-type annular structures 11 in the overlapping area OA. In this way, the first p-type annular subregion 51 constitutes a variation lateral doping ring.

In some embodiments of the present disclosure, as shown in FIG. 2b, the depth h2 of the part of each of the p-type annular structures 11 in the overlapping area OA is continuously varying, and the minimum value thereof is related to the overlapping degree of the two p-type annular structures 11. In some embodiments of the present disclosure, the depth h2 of the part of each of the p-type annular structures 11 in the overlapping area OA ranges from 0 to h1.

In the embodiment shown in FIG. 2a and FIG. 2b, the first p-type annular subregion 51 includes two p-type annular structures 11 in contact with each other as an example for description. In some embodiments, as shown in FIG. 2a, orthographic projections of the two p-type annular structures 11 on the n-type region 1 overlap each other, so that each of the p-type annular structures 11 includes an overlapping area OA and a non-overlapping area NOA. The depth of the part of each of the p-type annular structures 11 in the non-overlapping area NOA is greater than the depth of the part of each of the p-type annular structures 11 in the overlapping area OA. In some embodiments, as shown in FIG. 2a, the channel stopper region 9 is provided around the plurality of p-type annular subregions 5.

In the embodiment of the present disclosure, the orthographic projection refers to a projection formed on a surface of an object (e.g., the n-type region 1) by irradiating another object (e.g., the p-type annular structure 11) with light. In the embodiment of the present disclosure, the orthographic projections of the two p-type annular structures 11 on the n-type region 1 overlap each other. Based on this, it can be known that the direction of the light is from the p-type annular structure 11 to the n-type region 1, so that the orthographic projection of the p-type annular structure 11 is obtained, and this orthographic projection is on the surface of the n-type region 1. The adjacent p-type annular structures 11 correspond to the two orthographic projections, and the two orthographic projections are overlapped with each other, thus indicating that the adjacent p-type annular structures 11 overlap each other.

In the embodiment of the present disclosure, the p-type annular structures 11 are formed by ion implantation or the like. In the two adjacent p-type annular structures 11 formed by ion implantation or the like, the implanted ions in one of the p-type annular structures 11 diffuse into the other p-type annular structure 11, and the implanted ions in the other p-type annular structure 11 diffuse into the one p-type annular structure 11, that is, the orthographic projections of the two adjacent p-type annular structures 11 on the n-type region 1 overlap each other, so that each of the p-type annular structures 11 includes an overlapping area OA and a non-overlapping area NOA. That is, each of the p-type annular structures 11 includes the overlapping area OA overlapping with the adjacent p-type annular structure 11, and the non-overlapping area NOA not overlapping with the adjacent p-type annular structure 11.

In the embodiment of the present disclosure, the insulating layer 6 is made of an oxide, e.g. silicon oxide (e.g., thermal silicon oxide or a deposit of silicon oxide).

In the embodiment of the present disclosure, as shown in FIG. 2b, the depth of the part of each of the p-type annular structures 11 in the non-overlapping area NOA refers to a dimension of this part in the direction perpendicular to the surface of the n-type region 1. The depth of the part of each of the p-type annular structures 11 in the overlapping area OA refers to a dimension of this part in the direction perpendicular to the surface of the n-type region 1.

In the embodiment of the present disclosure, the plurality of p-type annular subregions 5 are all annular, for example, as shown in FIG. 2a, the plurality of p-type annular subregions 5 are square rings. However, the present disclosure is not limited thereto. Alternatively, the plurality of p-type annular subregions 5 are annular structures of other shapes, such as circular rings, hexagonal rings and other polygonal annular structures.

In the embodiment of the present disclosure, as shown in FIG. 2b, the first conductive layer 7 includes a first portion 12, and a plurality of second portions 13 provided around the first portion 12 in the terminal area TA, spaced apart from the first portion 12 and also spaced apart from each other, where the first portion 12 extends from a part of the active area AA, crossing a junction between the active area AA and the terminal area TA, to a part of the terminal area TA; each of the second portions 13 corresponds to one insulating layer opening 10; all the second portions 13 respectively correspond to the different insulating layer openings 10; and in the p-type region 4 and the plurality of p-type annular structures 11, the first p-type annular structure 11 in contact with the p-type region 4 contacts (for example, directly contacts) the first portion 12 through the same insulating layer opening 10 (i.e., the first insulating layer opening) closest to p-type region 4 in the plurality of insulating layer openings 10, and the other p-type annular structures 11 respectively contact (for example, directly contact) the corresponding second portions 13 through the corresponding insulating layer openings 10 (i.e., the second insulating layer openings). In the embodiment of the present disclosure, the first portion 12 and the plurality of the second portions 13 serve as metal field plates.

In the embodiment of the present disclosure, as shown in FIG. 2a and FIG. 2b, the plurality of p-type annular subregions 5 further includes a plurality of second p-type annular subregions 52 distributed around the first p-type annular subregion 51 and spaced apart from each other; the plurality of second p-type annular subregions 52 are sequentially disposed in a direction from the active area AA to the terminal area TA; and the plurality of second p-type annular subregions 52 respectively contact the corresponding second portions 13 through the corresponding insulating layer openings 10 (i.e., the second insulating layer openings) of the plurality of insulating layer openings 10.

In the present disclosure, there is no limitation on the length of the first p-type annular subregion 51 and the length of each of the second p-type annular subregions 52. The length of the first p-type annular subregion 51 refers to a dimension of the first p-type annular subregion 51 in the direction from the active area AA toward the terminal area TA. The length of each of the second p-type annular subregions 52 refers to a dimension of the second p-type annular subregion 52 in the direction from the active area AA toward the terminal area TA. In the embodiment of the present disclosure, the length of the first p-type annular subregion 51 may or may not be equal to that of each of the second p-type annular subregions 52. As shown in FIG. 2b, the channel stopper region 9 is in contact with one of the second portions 13 through one insulating layer opening.

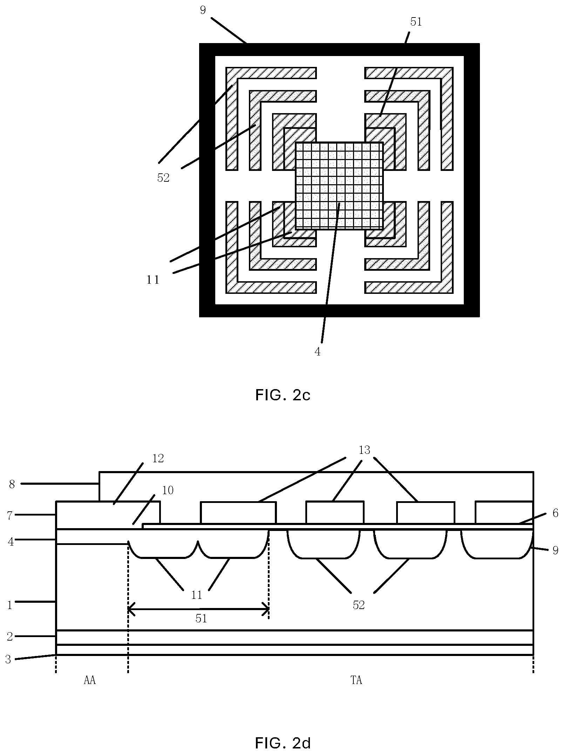

In some embodiments, each of the p-type annular subregions 5 is a continuously formed annular region (as shown in FIG. 2a). In an alternative embodiment, each of the p-type annular subregions 5 is a discontinuous annular region (as shown in FIG. 2c), that is, each of the p-type annular subregions 5 includes a plurality of portions spaced apart from each other. In some embodiments, each of the p-type annular structures 11 is a continuously formed annular region (as shown in FIG. 2a). In an alternative embodiment, each of the p-type annular structures 11 is a discontinuous annular region (as shown in FIG. 2c), that is, each of the p-type annular structures 11 includes a plurality of portions spaced apart from each other. In some embodiments, each of the second p-type annular subregions 52 is a continuously formed annular region (as shown in FIG. 2a). In an alternative embodiment, each of the second p-type annular subregions 52 is a discontinuous annular region (as shown in FIG. 2c), that is, each of the second p-type annular subregions 52 includes a plurality of portions spaced apart from each other.

FIG. 2c only illustrates an exemplary case of a discontinuous annular region, as long as all the portions of each of the p-type annular structures 11 and all the portions of each of the second p-type annular subregions 52 separately constitute a ring-shaped region as a whole.

FIG. 2d is a cross-sectional view of another structure of the semiconductor device provided according to the embodiment of the present disclosure. In the embodiment of the present disclosure, the insulating layer 6 may only consist of the one first insulating layer opening 10, without the plurality of second insulating layer openings. That is, the insulating layer 6 is provided such that the plurality of second p-type annular subregions 52 are electrically insulated from the first conductive layer 7. In the p-type region 4 and the plurality of p-type annular structures 11, the first p-type annular structure 11 in contact with the p-type region 4 contacts (for example, directly contacts) the first portion 12 through the first insulating layer opening 10, and the other p-type annular structures 11 do not contact the second portions 13. In the embodiment shown in FIG. 2d, the plurality of second portions 13 of the first conductive layer 7 are floating. As shown in FIG. 2d, the channel stopper region 9 is electrically insulated from the first conductive layer 7.

In the embodiment of the present disclosure, as shown in FIG. 2b, in a plane (i.e., in the cross section as shown in FIG. 2b) perpendicular to the surface of the n-type region 1 and parallel to the direction from the active area AA to the terminal area TA, a recess RE is formed in an area where any two adjacent p-type annular structures 11 are in contact with each other, and the recess RE is recessed towards a direction away from the n-type region 1; and thus the overlapping of the two p-type annular structures 11 results in the recess RE, that is, the recess RE is located within an overlapping area OA.

In the embodiment of the present disclosure, the first conductive layer 7 forms ohmic contact with the plurality of p-type annular subregions 5, the plurality of p-type annular structures 11 and the p-type region 4. In the embodiment of the present disclosure, the plurality of p-type annular subregions 5, the plurality of p-type annular structures 11 and the p-type region 4 are heavily doped, thereby facilitating the formation of the ohmic contact. Specifically, in the p-type region 4 and the plurality of p-type annular structures 11, the p-type annular structures 11 in contact with the p-type region 4 form ohmic contact with the first portion 12 through the same insulating layer opening 10 closest to p-type region 4 in the plurality of insulating layer openings 10, and the other p-type annular structures 11 respectively form ohmic contact with the corresponding second portions 13 through the corresponding insulating layer openings 10. The plurality of second p-type annular subregions 52 respectively form ohmic contact with the corresponding second portions 13 through the corresponding insulating layer openings 10.

In the embodiment of the present disclosure, the n-type region 1 may be made of any suitable material, e.g. silicon. In the embodiment of the present disclosure, the substrate dopants of the p-type region 4, the plurality of p-type annular structures 11 and the plurality of second p-type annular subregions 52 may be any suitable material, e.g. boron and aluminum. That is, the p-type region 4, the plurality of p-type annular structures 11 and the plurality of second p-type annular subregions 52 are formed by implanting boron or aluminum ions into the n-type region 1. In the embodiment of the present disclosure, the n+ type diffusion layer 2 is formed by implanting phosphorus ions, arsenic ions, or antimony ions into the n-type region 1.

In the optional embodiments of the present disclosure, the doping concentration of the plurality of p-type annular structures 11 may be the same as or different from the doping concentration of the plurality of second p-type annular subregions 52. In the embodiment of the present disclosure, the doping depth of the plurality of p-type annular structures 11 may be the same as or different from the doping depth of the plurality of second p-type annular subregions 52.

In the embodiment of the present disclosure, the doping concentration of each of the p-type annular structures 11 may be within a range of 1E15 cm⁻³ to 1E20 cm⁻³. In the embodiment of the present disclosure, the doping concentration of each of the second p-type annular subregions 52 may be within a range of 1E15 cm⁻³ to 1E20 cm⁻³.

In the embodiment of the present disclosure, the doping depth of each of the p-type annular structures 11 may be within a range of 2 µm to 50 µm. In the embodiment of the present disclosure, the doping depth of each of the second p-type annular subregions 52 may be within a range of 2 µm to 50 µm.

In the embodiment of the present disclosure, as shown in FIG. 2a and FIG. 2b, it is only schematically illustrated that the plurality of p-type annular subregions 5 include two second p-type annular subregions 52. However, the present disclosure is not limited thereto. In other embodiments, the plurality of p-type annular subregions 5 may also include other numbers of second p-type annular subregions 52. In the embodiment of the present disclosure, there is no limitation on the number of the plurality of p-type annular structures 11 of the first p-type annular subregion 51. There is also no limitation on the number of the second p-type annular subregions 52. In an alternative embodiment, the plurality of second p-type annular subregions 52 may not be included, and instead only one first p-type annular subregion 51 is included, and distributed within the entire terminal area TA.

In the embodiment of the present disclosure, as shown in FIG. 2b, the doping depth of the plurality of p-type annular subregions 52 is greater than that of the p-type region 4.

In the embodiment of the present disclosure, the doping concentration of the p-type region 4 may be within a range of 1E15 cm⁻³ to 1E20 cm⁻³. In the embodiment of the present disclosure, the doping depth of the p-type region 4 may be within a range of 2 µm to 50 µm.

As shown in FIG. 2a and FIG. 2b, an orthographic projection of the p-type annular structure 11 in contact with the p-type region 4 on the n-type region 1 overlaps with that of the p-type region 4 on the n-type region 1, and the orthographic projection refers to a projection formed on a surface of the n-type region 1 by the p-type annular structure 11 perpendicular to the surface of the n-type region 1.

In the embodiment of the present disclosure, as shown in FIG. 2a and FIG. 2b, the doping concentration and doping depth of the part of each of the p-type annular structures 11 in the overlapping area OA are smaller than those of the other parts of each of the p-type annular structures 11, respectively.

In the semiconductor device in the embodiment as shown in FIG. 2a and FIG. 2b, the first p-type annular subregion 51 includes two p-type annular structures 11 in contact with each other, each of the p-type annular structures 11 corresponding to one insulating layer opening 10; and all the p-type annular structures 11 respectively correspond to the different insulating layer openings 10. The plurality of p-type annular structures 11 contact the first conductive layer 7 through the corresponding insulating layer openings 10. In this way, the electric field, current distribution, and carrier distribution of the semiconductor device of the present disclosure are more uniform, the current concentration phenomenon thereof is alleviated, the ability to prevent dynamic avalanche breakdown of the semiconductor device of the present disclosure is improved, and the durability of the semiconductor device of the present disclosure is improved.

For semiconductor devices provided by the embodiments according to the present disclosure, such as an ultra-fast diode/a hyper-fast diode, a metal-oxide-semiconductor field effect transistor (MOSFET) and an insulated-gate bipolar transistor (IGBT), the durability thereof is greatly improved, and they have better reverse recovery behavior when being in a reverse recovery state.

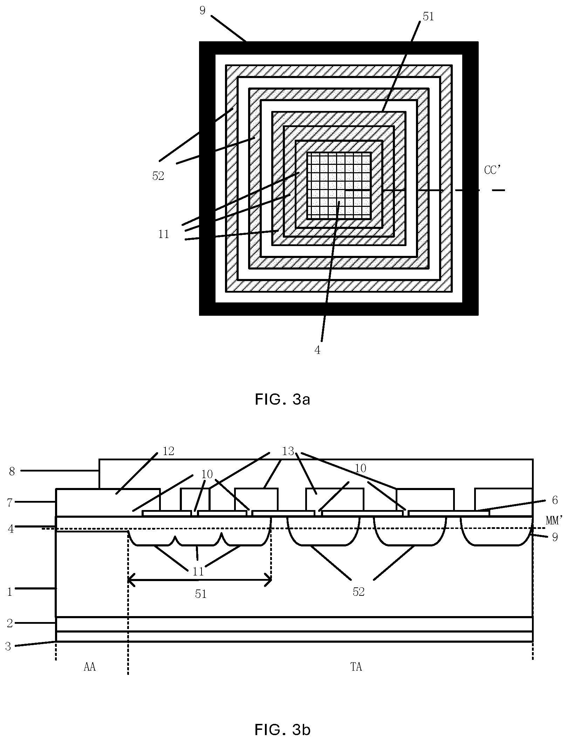

FIG. 3a is a top view of another structure of the semiconductor device provided according to the embodiment of the present disclosure. FIG. 3b is a cross-sectional view along a line CC' in FIG. 3a. In the embodiment of the present disclosure, compared with the structure of the semiconductor device shown in FIG. 2a and FIG. 2b, the difference lies in that, as shown in FIG. 3a and FIG. 3b, the first p-type annular subregion 51 includes three p-type annular structures 11 in contact with each other, each of the p-type annular structures 11 corresponding to one insulating layer opening 10. All the p-type annular structures 11 respectively correspond to the different insulating layer openings 10. The plurality of p-type annular structures 11 contact the first conductive layer 7 through the corresponding insulating layer openings 10.

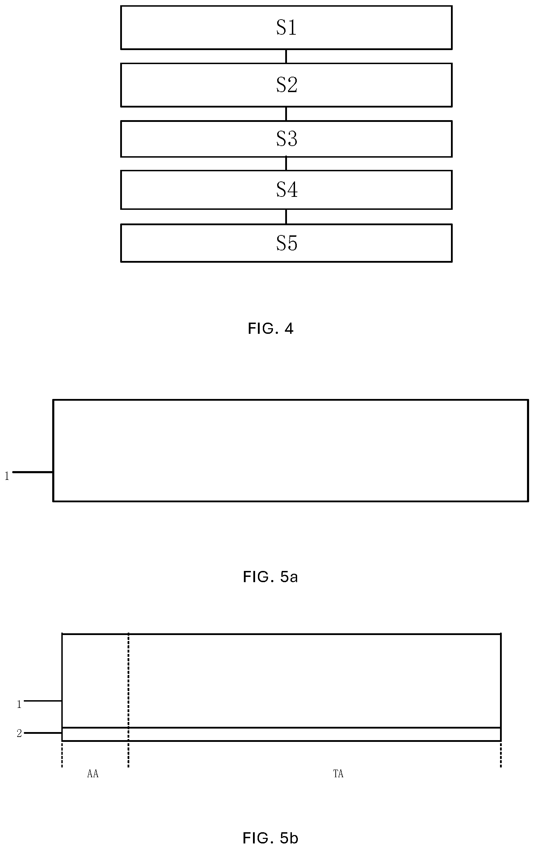

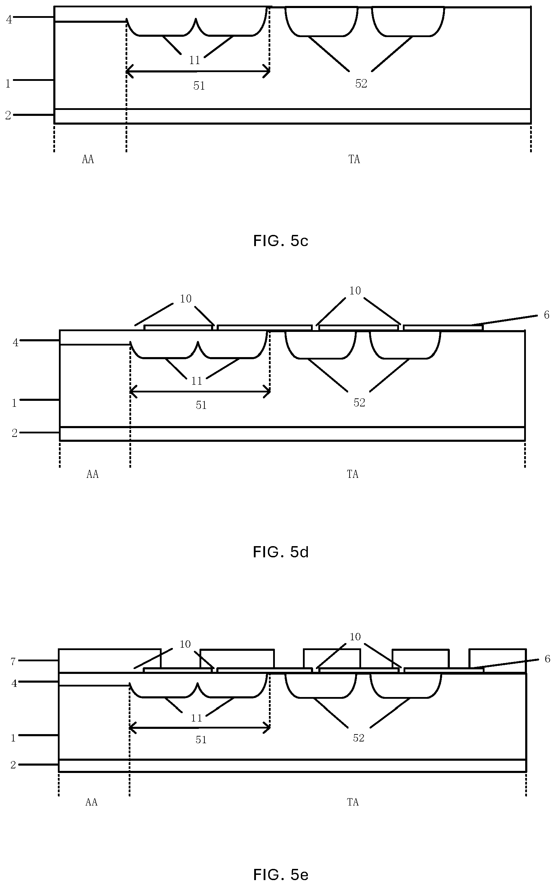

In another aspect, the present disclosure provides a method for manufacturing the semiconductor device. FIG. 4 is a flowchart of the method for manufacturing the semiconductor device according to the embodiment of the present disclosure. FIG. 5a to FIG. 5e illustrate cross-sectional views of all steps of the method for manufacturing the semiconductor device according to the embodiment of the present disclosure. FIG. 5a to FIG. 5e illustrate the cross-sectional views of all the steps of the method for manufacturing the semiconductor device with the embodiment shown in FIG. 2a and FIG. 2b as an example. As shown in FIG. 4, the method for manufacturing the semiconductor device according to the embodiment of the present disclosure includes the following steps:
S1, as shown in FIG. 5a, providing a semiconductor substrate 1 having a first conductivity type (e.g. an n-type semiconductor substrate as shown in FIG. 2a, where the n-type semiconductor substrate may be used as an n-type region 1 of the semiconductor device as shown in FIG. 1a), where the semiconductor substrate 1 includes a first side and a second side opposite to each other;
S2, as shown in FIG. 5b, forming a contact region having the first conductivity type on a first side of the n-type region 1, where the contact region may be an n+ type diffusion layer 2 in contact with the n-type region 1, for example, where
in the embodiment of the present disclosure, the semiconductor device has an active area AA and a terminal area TA surrounding the active area AA; in the embodiment of the present disclosure, the n-type region 1 may be made of any suitable material, e.g. a semiconductor substrate of n-type doped silicon; in the embodiment of the present disclosure, the n+ type diffusion layer 2 is formed by further implanting phosphorus ions, arsenic ions, or antimony ions into the n-type region 1;
S3, as shown in FIG. 5c, forming a base region having a second conductivity type on the second side of the n-type region 1, where the base region may be a p-type region 4 located in the active area AA, for example; and forming a plurality of annular subregions having the second conductivity type on the second side of the n-type region 1, where as shown in FIG. 2a, the plurality of annular subregions 5 are located in the terminal area TA and spaced apart from each other, where
in the embodiment of the present disclosure, the plurality of p-type annular subregions 5 and the p-type region 4 are formed by implanting boron or aluminum ions into the semiconductor substrate e.g. the n-type region 1; in the embodiment of the present disclosure, the step (i.e., step S2) of forming the n+ type diffusion layer 2 on the first side of the n-type region 1 may be performed before or after the step (i.e., step S3) of forming the p-type region 4 on the second side of the n-type region 1 and forming the plurality of p-type annular subregions 5 on the second side of the n-type region 1; in the step (i.e., step S3) of forming the p-type region 4 on the second side of the n-type region 1 and forming the plurality of p-type annular subregions 5 on the second side of the n-type region 1, the p-type region 4 and the plurality of p-type annular subregions 5 may be formed at the same time or be not formed at the same time, without limitation;
S4, as shown in FIG. 5d, forming an insulating layer 6 on one sides of the plurality of p-type annular subregions 5 away from the n-type region 1, where the insulating layer is located in the terminal area TA and provided with a plurality of insulating layer openings 10, where
in the embodiment of the present disclosure, the plurality of insulating layer openings 10 are formed by patterning and etching processes; in the embodiment of the present disclosure, the insulating layer 6 is made of an oxide, e.g. silicon oxide (e.g., thermal silicon oxide or a deposit of silicon oxide); and
S5, as shown in FIG. 5e, forming a first conductive layer 7 on one sides of the p-type region 4 and the insulating layer 6 away from the n-type region 1, where the first conductive layer is located in the active area AA and the terminal area TA.

In the embodiment of the present disclosure, the one sides of the p-type region 4 and the insulating layer 6 away from the n-type region 1 are coated with a conductive layer material (such as aluminum-silicon alloy) by a sputtering process, and the conductive layer material is patterned, etched, and sintered to form the first conductive layer 7.

In the embodiment of the present disclosure, forming the plurality of p-type annular subregions 5 includes forming a first p-type annular subregion 51. The first p-type annular subregion 51 is in contact with the p-type region 4. Forming the first p-type annular subregion 51 includes forming a plurality p-type annular structures 11 in contact with each other, each of the p-type annular structures 11 corresponding to one insulating layer opening 10. All the p-type annular structures 11 respectively correspond to the different insulating layer openings 10; and the plurality of p-type annular structures 11 contact the first conductive layer 7 through the corresponding insulating layer openings 10.

In the embodiment of the present disclosure, forming the plurality of p-type annular subregions 5 further includes forming a plurality of second p-type annular subregions 52 distributed around the first p-type annular subregion 51 and spaced apart from each other, where the plurality of second p-type annular subregions 52 are sequentially disposed in a direction from the active area AA to the terminal area TA; and the plurality of second p-type annular subregions 52 respectively contact corresponding second portions 13 through the corresponding insulating layer openings 10 of the plurality of insulating layer openings 10.

In the embodiment of the present disclosure, the first p-type annular subregion 51 and the plurality of second p-type annular subregions 52 may be formed at the same time or be not formed at the same time, without limitation.

In an alternative embodiment, the insulating layer 6 may only consist of the one first insulating layer opening 10, without the plurality of second insulating layer openings. That is, the insulating layer 6 is provided such that the plurality of second p-type annular subregions 52 are electrically insulated from the first conductive layer 7. In the p-type region 4 and the plurality of p-type annular structures 11, the first p-type annular structure 11 in contact with the p-type region 4 contacts (for example, directly contacts) a first portion 12 through the first insulating layer opening 10, and the other p-type annular structures 11 do not contact the second portions 13.

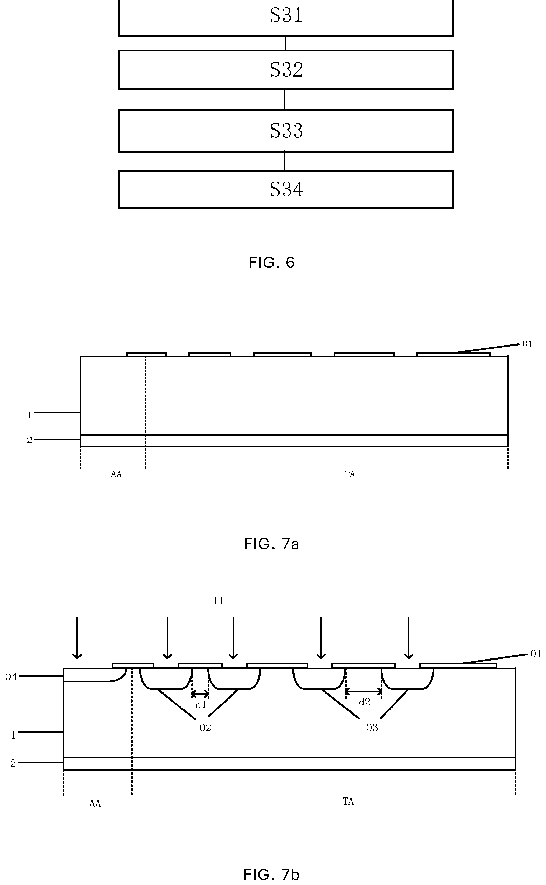

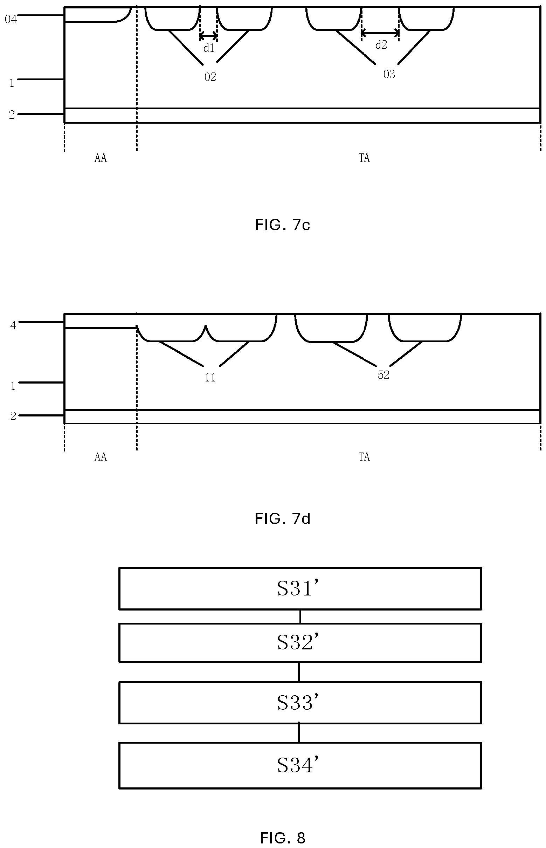

FIG. 6 illustrates a specific process of forming the plurality of p-type annular subregions on the second side of the n-type region in step S3 of the method for manufacturing the semiconductor device according to the embodiment of the present disclosure. FIG. 7a to FIG. 7d illustrate cross-sectional views of all steps of forming the plurality of p-type annular subregions on the second side of the semiconductor substrate in step S3 of the method for manufacturing the semiconductor device according to the embodiment of the present disclosure. FIG. 7a to FIG. 7d illustrate the cross-sectional views of all the steps of forming the plurality of p-type annular subregions on the second side of the n-type region in step S3 of the method for manufacturing the semiconductor device with the embodiment shown in FIG. 2a and FIG. 2b as an example. As shown in FIG. 6, in the embodiment of the present disclosure, forming the plurality of p-type annular subregions 5 on the second side of the n-type region 1 includes the following steps:
S31, as shown in FIG. 7a, coating the second side of the n-type region 1 with a photoresist layer to form a photoresist pattern 01;
S32, as shown in FIG. 7b, forming a plurality of p-type annular layers 02 and a plurality of second p-type annular sublayers 03 by means of ion implantation (marked as II in FIG. 7b) under the condition that the photoresist pattern 01 is used as a mask, with the adjacent p-type annular layers 02 being spaced apart by a first spacing d1, and the adjacent second p-type annular sublayers 03 being spaced apart by a second spacing d2, where the first spacing d1 is smaller than the second spacing d2, and the adjacent p-type annular layer 02 and the second p-type annular sublayer 03 may also be spaced apart by the second spacing d2, where
in the embodiment of the present disclosure, forming the p-type region 4 on the second side of the n-type region 1 in step S3 includes the following steps: in step S32, as shown in FIG. 7b, forming a p-type layer 04 by means of ion implantation under the condition that the photoresist pattern 01 is used as a mask while forming the plurality of p-type annular layers 02 and the plurality of second p-type annular sublayers 03, where the adjacent p-type annular layer 02 is spaced apart from the p-type layer 04;
S33, as shown in FIG. 7c, removing the photoresist pattern 01; and
S34, as shown in FIG. 7d, performing high-temperature treatment on the plurality of p-type annular layers 02 and the plurality of second p-type annular sublayers 03 to further diffuse the implanted ions, making it possible to form the plurality of p-type annular structures 11 and the plurality of second p-type annular subregions 52, and further allowing orthographic projections of any two adjacent p-type annular structures 11 on the n-type region 1 to overlap each other, with each of the p-type annular structures 11 including an overlapping area OA and a non-overlapping area NOA, where the orthographic projections are formed on a surface of the n-type region 1 by the p-type annular structures 11 perpendicular to the surface of the n-type region 1, while the orthogonal projections of any two adjacent second p-type annular subregions 52 on the n-type region 1 do not overlap each other. The orthographic projections of the adjacent second p-type annular subregion 52 and the p-type annular structure 11 on the n-type region 1 do not overlap each other; and the depth of the part of each of the p-type annular structures 11 in the non-overlapping area NOA is greater than the depth of the part of each of the p-type annular structures 11 in the overlapping area OA. In this way, the first p-type annular subregion 51 constitutes a variation lateral doping ring.

In the embodiment of the present disclosure, the first spacing d1 satisfies the following condition: 0<d1<2×X0, where X0 represents the depth of the part of each of the p-type annular structures 11 in the non-overlapping area NOA. Preferably, the first spacing d1 is 0.5×X0, 1.0×X0 or 1.5×X0. In the embodiment of the present disclosure, the second spacing d2 satisfies the following condition: d2>2×X0. Therefore, in the formation of the plurality of p-type annular subregions 5 through the above steps S31 to S34, the orthogonal projections of any two adjacent p-type annular structures 11 on the n-type region 1 overlap each other, while the orthogonal projections of any two adjacent second p-type annular subregions 52 on the n-type region 1 do not overlap each other. The orthographic projections of the adjacent second p-type annular subregion 52 and the p-type annular structure 11 on the n-type region 1 do not overlap each other.

In the embodiment of the present disclosure, during the high-temperature treatment, the maximum temperature may be 1150°C, 1175°C, 1200°C, or 1250°C; and the time of duration at the maximum temperature may be 60 min, 120 min, ..., or 900 min. The maximum temperature and the time of duration may be determined according to actual needs, and are not limited thereto.

In the embodiment of the present disclosure, forming the p-type region 4 on the second side of the n-type region 1 in step S3 includes the following steps: in step S34, as shown in FIG. 7d, enabling the p-type layer 04 to be subjected to high-temperature treatment while the plurality of p-type annular layers 02 and the plurality of second p-type annular sublayers 03 are subjected to high-temperature treatment, so as to further diffuse the implanted ions and thus form the p-type region 4, where the orthographic projection of the p-type annular structure 11 in contact with the p-type region 4 on the n-type region 1 overlaps that of the p-type region 4 on the n-type region 1, and the orthographic projection is formed on the surface of the n-type region 1 by the p-type annular structure 11 perpendicular to the surface of the n-type region 1.

In the embodiment of the present disclosure, there is no limitation on the number of the plurality of p-type annular structures 11 in the first p-type annular subregions 51. The number of the second p-type annular subregions 52 is also not limited. In an alternative embodiment, the plurality of second p-type annular subregions 52 may not be included, and instead only one first p-type annular subregion 51 is included, and distributed within the entire terminal area TA.

FIG. 8 illustrates a specific process of forming the plurality of p-type annular subregions on the second side of the n-type region in step S3 of a method for manufacturing the semiconductor device according to an alternative embodiment of the present disclosure. As shown in FIG. 8, in the embodiment of the present disclosure, forming the plurality of p-type annular subregions 5 on the second side of the n-type region 1 includes the following steps:
S31', coating the second side of the n-type region 1 with a photoresist layer to form a photoresist pattern;
S32', forming a plurality of p-type annular layers by means of ion implantation under the condition that the photoresist pattern is used as a mask, with the adjacent p-type annular layers being spaced apart by a first spacing d1;
S33', removing the photoresist pattern; and
S34', performing high-temperature treatment on the plurality of p-type annular layers to further diffuse the injected ions, making it possible to form the plurality of p-type annular structures 11, and further allowing orthographic projections of any two adjacent p-type annular structures 11 on the n-type region 1 to overlap each other, with each of the p-type annular structures 11 including an overlapping area OA and a non-overlapping area NOA, where the orthographic projections are formed on a surface of the n-type region 1 by the p-type annular structures 11 perpendicular to the surface of the n-type region 1; and the depth of the part of each of the p-type annular structures 11 in the non-overlapping area NOA is greater than that of the part of each of the p-type annular structures 11 in the overlapping area OA.

In the embodiment of the present disclosure, after the step (i.e., step S6) of forming the first conductive layer 7 on one sides of the p-type region 4 and the insulating layer 6 away from the n-type region 1, the method further includes: forming a second conductive layer 3 on the side of the n+ type diffusion layer 2 away from the n-type region 1; and forming a passivation layer 8 on the side of the first conductive layer 7 away from the n-type region 1. In the embodiment of the present disclosure, after the step (i.e., step S3) of forming the p-type region 4 on the second side of the n-type region 1 and forming the plurality of p-type annular subregions 5 on the second side of the n-type region 1, the method further includes: forming the channel stopper region 9 located in the terminal area TA and on the second side of the n-type region 1, and spaced apart from the plurality of p-type annular subregions 5. In some embodiments, the channel stopper region 9 is provided around the plurality of p-type annular subregions 5.

The electric field, current distribution, and carrier distribution of the semiconductor device manufactured by the method provided according to the embodiment of the present disclosure are more uniform, the current concentration phenomenon thereof is alleviated, the ability to prevent dynamic avalanche breakdown of the semiconductor device of the present disclosure is improved, and the durability of the semiconductor device of the present disclosure is improved.

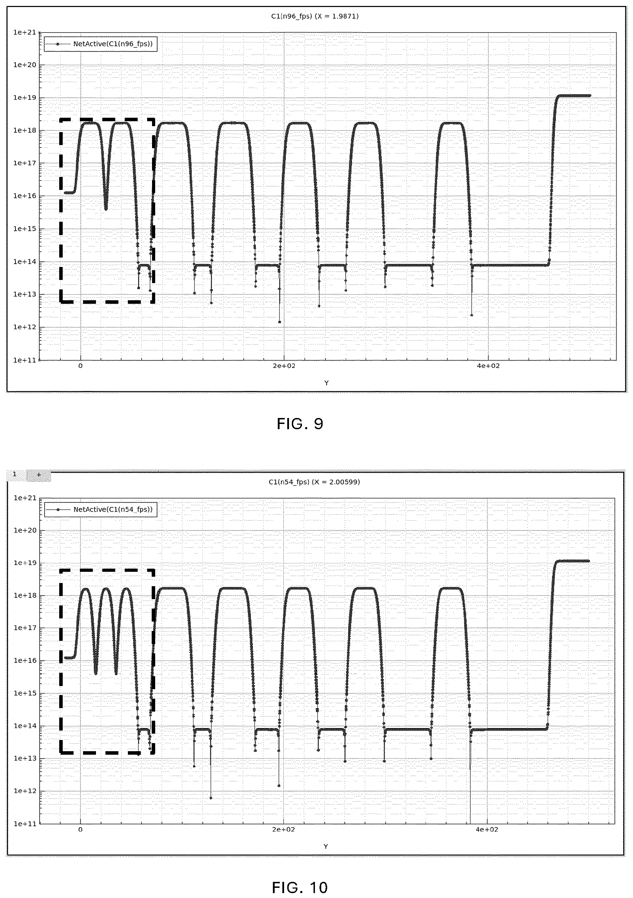

FIG. 9 illustrates doping profiles of the p-type annular subregions 5 along a dashed line LL' in FIG. 2b according to the embodiment of the present disclosure. As shown in FIG. 9, the abscissa represents the distance along the dashed line LL', measured in µm; and the ordinate represents the doping profiles, measured in cm⁻³. The doping profiles of the two p-type annular structures 11 of the first p-type annular subregion 51 are indicated in the dashed box. FIG. 9 shows the doping profiles of the plurality of second p-type annular subregions 52 and the two p-type annular structures 11 of the first p-type annular subregion 51. At the overlapping areas OAs of the p-type annular structures 11 in contact with each other, the doping profile of the part of each of the p-type annular structures 11 in the non-overlapping area NOA is significantly larger than the doping profile of the part of each of the p-type ring structures 11 in the overlapping area OA. The doping profile of each of the second p-type annular subregions 52 is substantially the same as the doping profile of the part of each of the p-type annular structures 11 in the non-overlapping area NOA.

FIG. 10 illustrates doping profiles of the p-type annular subregions 5 along a dashed line MM' in FIG. 3b according to the embodiment of the present disclosure. Similar to FIG. 9, in FIG. 10, the abscissa represents the distance along the dashed line LL', measured in µm; and the ordinate represents the doping profiles, measured in cm⁻³. The doping profiles of the three p-type annular structures 11 of the first p-type annular subregion 51 are indicated in the dashed box. FIG. 10 shows the doping profiles of the plurality of second p-type annular subregions 52 and the three p-type annular structures 11 of the first p-type annular subregion 51. At the overlapping areas OAs of the p-type annular structures 11 in contact with each other, the doping profile of the part of each of the p-type annular structures 11 in the non-overlapping area NOA is significantly larger than the doping profile of the part of each of the p-type ring structures 11 in the overlapping area OA. The doping profile of each of the second p-type annular subregions 52 is substantially the same as the doping profile of the part of each of the p-type annular structures 11 in the non-overlapping area NOA.

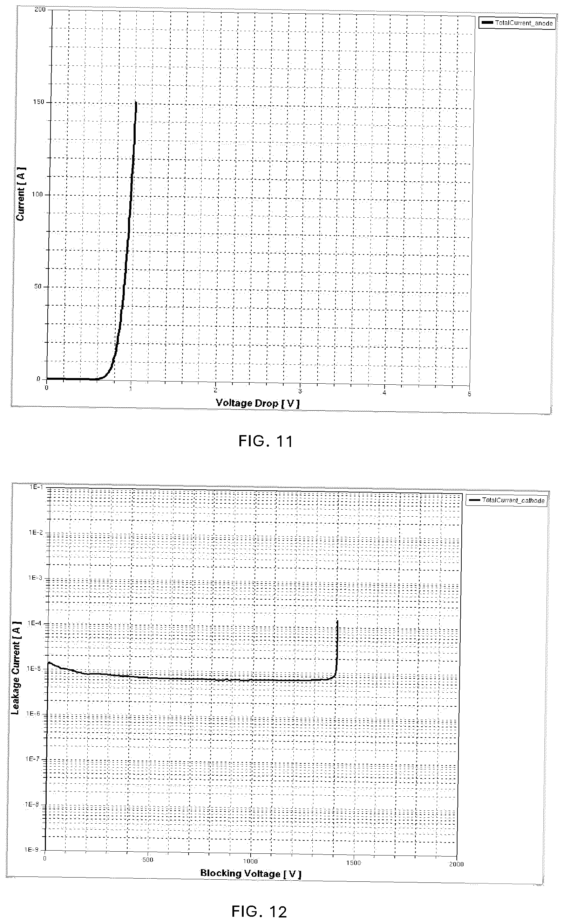

FIG. 11 illustrates a relationship between voltage drop and current of the semiconductor device according to the embodiment of the present disclosure. FIG. 12 illustrates a relationship between blocking voltage and leakage current of the semiconductor device according to the embodiment of the present disclosure. As shown in FIG. 11, the abscissa represents the voltage drop, and the ordinate represents the current. When the voltage drop reaches a range of 0.8 to 1V, the current abruptly changes from 0A to 150A. As shown in FIG. 12, the abscissa represents the blocking voltage, and the ordinate represents the leakage current. When the blocking voltage is 1400 V, the leakage current suddenly increases.

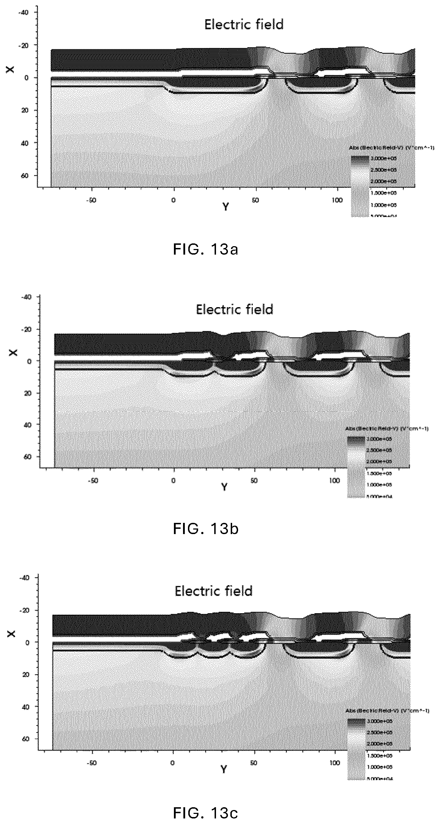

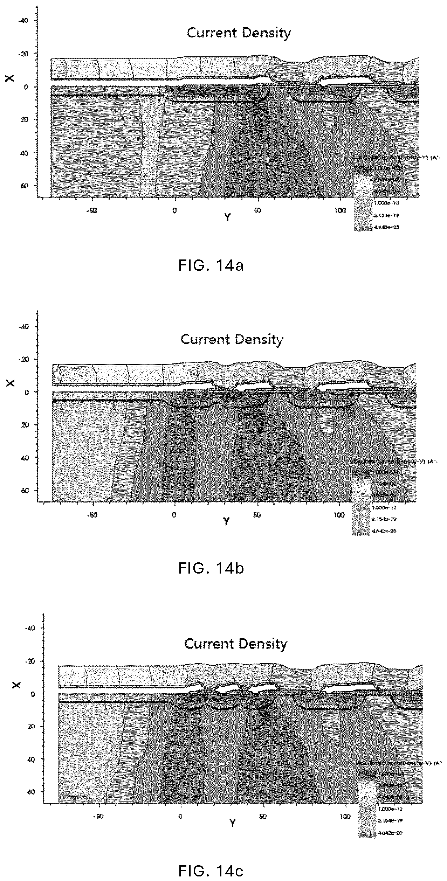

FIG. 13a shows the electric field distribution of the semiconductor device in the related art as shown in FIG. 1b. FIG. 13b shows the electric field distribution of the semiconductor device according to the embodiment of the present disclosure as shown in FIG. 2b. FIG. 13c shows the electric field distribution of the semiconductor device according to the embodiment of the present disclosure as shown in FIG. 3b. FIG. 14a shows the current density distribution of the semiconductor device in the related art as shown in FIG. 1b. FIG. 14b shows the current density distribution of the semiconductor device according to the embodiment of the present disclosure as shown in FIG. 2b. FIG. 14c shows the current density distribution of the semiconductor device according to the embodiment of the present disclosure as shown in FIG. 3b. As shown in FIG. 13a to FIG. 13c and FIG. 14a to FIG. 14c, the abscissa Y and the ordinate X represent a distance in the direction from the active area AA to the termination area TA and a distance in the direction perpendicular to the surface of the n-type region 1, respectively; and the current density is represented by the shade of color, and the darker the color, the greater the current density.

In the semiconductor device based on the related art, as shown in FIG. 14a, higher current density leads to current concentration, easily resulting in burnout of the semiconductor device. In the semiconductor device according to the embodiment of the present disclosure, as shown in FIG. 14b and FIG. 14c, the current is distributed to two regions, and the current distribution is more uniform, thereby reducing the current density, relieving current concentration and avoiding the burnout of the semiconductor device.

Each of the p-type annular structures 11 in the semiconductor device according to the embodiment of the present disclosure has a varying doping profile in the non-overlapping area NOA and the overlapping area OA, so that the first p-type annular subregion 51 constitutes a variation lateral doping ring; and therefore, the electric field distribution and current density distribution of the semiconductor device are improved, the durability of the semiconductor device is further improved, and the semiconductor device is enabled to have better reverse recovery behavior when being in a reverse recovery state.

The foregoing descriptions of the embodiments of the present disclosure have been presented for the purposes of illustration and description. It is not exhaustive, nor is it intended to limit the present disclosure to the precise form or exemplary embodiments disclosed. Accordingly, the foregoing descriptions should be regarded as illustrative rather than restrictive. Obviously, many modifications and variations will be obvious to those skilled in the art. The embodiments are chosen and described for the purpose of explaining the principles of the present disclosure and its optimal mode in practical application, so that those skilled in the art can understand the various embodiments of the present disclosure, and the embodiments are suited to various modifications for the specific use or implementation being considered. It is intended that the scope of the present disclosure is defined by the appended claims and their equivalents, where unless otherwise stated, all terms imply their widest reasonable meaning. Thus, the terms "present disclosure", and the like do not necessarily limit the scope of the claims to specific embodiments; and reference to exemplary embodiments of the present disclosure does not imply a limitation on the present disclosure, and no such limitation should be inferred. The present disclosure is limited only by the spirit and scope of the appended claims. In addition, these claims may refer to the use of "first", "second", and the like, followed by nouns or elements. These terms should be understood as nomenclature, and should not be construed as limiting the number of elements modified by such nomenclature, unless a specific quantity has already been given. Any of the advantages and benefits described may not be applicable to all the embodiments of the present disclosure. It will be appreciated that those skilled in the art may make changes to the described embodiments without departing from the scope of the present disclosure as defined by the appended claims. Moreover, none of the elements and components in the present disclosure are intended to be contributed to the public, whether or not such elements or components are explicitly recited in the appended claims.

### List of Reference Numerals

| Reference numerals | Element | Reference numerals | Element |
|---|---|---|---|
| AA | active area | TA | terminal area |
| 1 | n-type region | 2 | n+ type diffusion layer |
| 3 | second conductive layer | 4 | p-type region |
| 5 | p-type annular subregions | 6 | insulating layer |
| 7 | first conductive layer | 8 | passivation layer |
| 9 | channel stopper region | 10 | insulating layer openings |
| 11 | p-type annular structures | 12 | first portion |
| 13 | second portions | 51 | first p-type annular subregions |
| 52 | second p-type annular subregions | 01 | photoresist pattern |
| 02 | p-type annular layers | 03 | second p-type annular sublayers |
| 04 | p-type layer | | |

## Claims

1. A semiconductor device, having an active area and a terminal area surrounding the active area, the semiconductor device comprising:
a semiconductor substrate having a first conductivity type, wherein the semiconductor substrate comprises a first side and a second side opposite to each other;
a base region having a second conductivity type, located in the active area and on the second side of the semiconductor substrate;
a plurality of annular subregions having the second conductivity type, located in the terminal area and on the second side of the semiconductor substrate, and spaced apart from each other;
an insulating layer, located in the terminal area and on one sides of the plurality of annular subregions away from the semiconductor substrate, wherein the insulating layer is provided with a first insulating layer opening; and
a first conductive layer, located in the active area and the terminal area and on one sides of the base region and the insulating layer away from the semiconductor substrate, wherein
the plurality of annular subregions comprise a first annular subregion, and the first annular subregion is in contact with the base region;
the first conductive layer comprises a first portion, and a plurality of second portions surrounding the first portion in the terminal area, wherein the first portion is spaced apart from the plurality of second portions and extends from a part of the active area, crossing a junction between the active area and the terminal area, to a part of the terminal area, and the plurality of second portions are spaced apart from each other; and
the first annular subregion comprises a plurality of annular structures in contact with each other and having the second conductivity type, and the base region and the first annular structure of the plurality of annular structures in contact with the base region come into contact with the first portion through the first insulating layer opening.

2. The semiconductor device according to claim 1, wherein the insulating layer is further provided with a plurality of second insulating layer openings;
each of the second portions of the first conductive layer corresponds to one second insulating layer opening, and all the second portions respectively correspond to the different second insulating layer openings; and
except for the first annular structure, the other annular structures are respectively in contact with the corresponding second portions through the respective second insulating layer openings.

3. The semiconductor device according to claim 2, wherein
the first conductivity type is n-type;
the second conductivity type is p-type; and
the semiconductor substrate is an n-type region, the base region is a p-type region, the plurality of annular subregions are a plurality of p-type annular subregions, the first annular subregion is a first p-type annular subregion, and the annular structures are p-type annular structures.

4. The semiconductor device according to claim 3, wherein the plurality of p-type annular subregions are all annular and are arranged around the p-type region;
in any two adjacent p-type annular structures, the p-type annular structure away from the p-type region is arranged around the p-type annular structure close to the p-type region;
orthographic projections of any two adjacent p-type annular structures on the n-type region overlap each other, so that each of the p-type annular structures comprises an overlapping area and a non-overlapping area; the orthographic projections are formed on a surface of the n-type region by the p-type annular structures perpendicular to the surface of the n-type region; and the depth of the part of each of the p-type annular structures in the non-overlapping area is greater than that of the part of each of the p-type annular structures in the overlapping area.

5. The semiconductor device according to claim 3, wherein the plurality of p-type annular subregions further comprise a plurality of second p-type annular subregions distributed around the first p-type annular subregion and spaced apart from each other, the plurality of second p-type annular subregions being sequentially disposed in a direction from the active area to the terminal area; and
the plurality of second p-type annular subregions respectively contact the corresponding second portions through the corresponding second insulating layer openings of the plurality of second insulating layer openings.

6. The semiconductor device according to claim 5, wherein in a plane perpendicular to a surface of the n-type region and parallel to a direction from the active area to the terminal area, a recess is formed in an area where any two adjacent p-type annular structures are in contact with each other, the recess being recessed towards a direction away from the n-type region.

7. The semiconductor device according to claim 5, wherein the doping concentration of the plurality of p-type annular structures is different from that of the plurality of second p-type annular subregions; and/or
the doping depth of the plurality of p-type annular structures is different from that of the plurality of second p-type annular subregions.

8. The semiconductor device according to claim 3, wherein the doping depth of the plurality of p-type annular subregions is greater than that of the p-type region.

9. The semiconductor device according to claim 3, wherein the plurality of p-type annular structures comprise two or three p-type annular structures.

10. The semiconductor device according to any one of claims 3 to 9, wherein an orthographic projection of the p-type annular structure contacting the p-type region on the n-type region overlaps an orthographic projection of the p-type region on the n-type region, the orthographic projection being a projection formed on the surface of the n-type region by the p-type annular structure perpendicular to the surface of the n-type region.

11. The semiconductor device according to claim 4, wherein the doping concentration and doping depth of the part of each of the p-type annular structures in the overlapping area are smaller than those of the other parts of each of the p-type annular structures, respectively.

12. A method for forming a semiconductor device, wherein the semiconductor device has an active area and a terminal area surrounding the active area; and the method comprises:
providing a semiconductor substrate having a first conductivity type, the semiconductor substrate comprising a first side and a second side opposite to each other;
forming a base region having a second conductivity type on the second side of the semiconductor substrate, the base region being located in the active area;
forming a plurality of annular subregions having the second conductivity type on the second side of the semiconductor substrate, the annular subregions being located in the terminal area and spaced apart from each other;
forming an insulating layer on one sides of the plurality of annular subregions away from the semiconductor substrate, the insulating layer being located in the terminal area and provided with a first insulating layer opening; and
forming a first conductive layer on one sides of the base region and the insulating layer away from the semiconductor substrate, the first conductive layer being located in the active area and
the terminal area, wherein
forming the plurality of annular subregions comprises forming a first annular subregion, the first annular subregion being in contact with the base region; and
forming the first conductive layer comprises forming a first portion, and forming a plurality of second portions surrounding the first portion in the terminal area and spaced apart from each other, wherein the first portion is formed to be spaced apart from the plurality of second portions,
and is allowed to extend from a part of the active area, crossing a junction between the active area and the terminal area, to a part of the terminal area; and
forming the first annular subregion comprises forming a plurality of annular structures having the second conductivity type and in contact with each other, where
the base region and the first annular structure of the plurality of annular structures in contact with the base region come into contact with the first portion through the first insulating layer opening.

13. The method according to claim 12, wherein the insulating layer is further provided with a plurality of second insulating layer openings;
each of the second portions of the first conductive layer corresponds to one second insulating layer opening, and all the second portions respectively correspond to the different second insulating layer openings; and
except for the first annular structure, the other annular structures are respectively in contact with the corresponding second portions through the respective second insulating layer openings.

14. The method according to claim 13, wherein
the first conductivity type is n-type;
the second conductivity type is p-type; and
the semiconductor substrate is an n-type region, the base region is a p-type region, the plurality of annular subregions are a plurality of p-type annular subregions, the first annular subregion is a first p-type annular subregion, and the annular structures are p-type annular structures.

15. The method according to claim 14, wherein forming the plurality of p-type annular subregions further comprises:
forming a plurality of second p-type annular subregions spaced apart from each other, the plurality of second p-type annular subregions being sequentially disposed in a direction from the active area to the terminal area, and spaced apart from the first p-type annular subregion, wherein
forming the first p-type annular subregion and forming the plurality of second p-type annular subregions are performed simultaneously.

16. The method according to claim 15, wherein forming the plurality of p-type annular subregions comprises:
coating the second side of the n-type region with a photoresist layer to form a photoresist pattern,
forming a plurality of p-type annular layers and a plurality of second p-type annular sublayers by means of ion implantation under the condition that the photoresist pattern is used as a mask,
with the adjacent p-type annular layers being spaced apart by a first spacing, and the adjacent second p-type annular sublayers being spaced apart by a second spacing, wherein the first spacing is smaller than the second spacing;
removing the photoresist pattern; and
performing high-temperature treatment on the plurality of p-type annular layers and the plurality of second p-type annular sublayers to further diffuse the implanted ions, making it possible to form a plurality of p-type annular structures and the plurality of second p-type annular subregions, and further allowing orthographic projections of any two adjacent p-type annular structures on the n-type region to overlap each other, with each of the p-type annular structures comprising an overlapping area and a non-overlapping area, the orthographic projections being formed on a surface of the n-type region by the p-type annular structures perpendicular to the surface of the n-type region, and the orthogonal projections of any two adjacent second p-type annular subregions on the n-type region not overlapping each other, wherein
the depth of the part of each of the p-type annular structures in the non-overlapping area is greater than that of the part of each of the p-type annular structures in the overlapping area.

17. The method according to claim 14, wherein forming the plurality of p-type annular subregions comprises:
coating the second side of the n-type region with a photoresist layer to form a photoresist pattern,
forming a plurality of p-type annular layers by means of ion implantation under the condition that the photoresist pattern is used as a mask, with the adjacent p-type annular layers being spaced apart by a first spacing;
removing the photoresist pattern; and
performing high-temperature treatment on the plurality of p-type annular layers to further diffuse the implanted ions, making it possible to form a plurality of p-type annular structures, and further allowing orthographic projections of any two adjacent p-type annular structures on the n-type region to overlap each other, with each of the p-type annular structures comprising an overlapping area and a non-overlapping area, the orthographic projections being formed on a surface of the n-type region by the p-type annular structures perpendicular to the surface of the n-type region, wherein
the depth of the part of each of the p-type annular structures in the non-overlapping area is greater than that of the part of each of the p-type annular structures in the overlapping area.
